# DEMANDE DE BREVET EUROPEEN

(11) **EP 4 656 900 A1**
(43) Date de publication de la demande: **03.12.2025**
(21) Numéro de dépôt: 25178033.4
(22) Date de dépôt: 21.05.2025
(51) Int. Cl.: F16F 1/10, G04B 17/06, G04D 7/10

(54) **PROCÉDÉ POUR FABRICATION DE SPIRAUX EN SILICIUM**

(30) Priorité: 28.05.2024 CH 563202024; 19.11.2024 CH 1251202024
(71) Demandeur: Sercalo Microtechnology Ltd., 9494 Schaan (LI)
(72) Inventeur: Perregaux, Gregoire, 2074 Marin-Epagnier (CH); Marxer, Cornel, 2000 Neuchâtel (CH)
(74) Mandataire: Swisspat Riederer Hasler Patentanwälte AG

(57) **Abrégé**

L'invention propose un procédé de fabrication d'un lot de spiraux en silicium à partir de plaquettes SOI (Silicon On Insulator) destiné à maintenir la valeur du couple élastique des spiraux dans une plage donnée. Ce procédé comprend, dans l'ordre, les étapes suivantes :
a - Photolithographie et gravure DRIE d'au moins une plaquette SOI, sur laquelle au moins une structure de spiral et une structure de mesure sont présents,
b - Mesure d'un paramètre de la structure de mesure, la valeur du paramètre de mesure étant corrélée à la valeur du couple élastique du spiral de façon connue,
c - Ajustement fin des paramètres de photolithographie et gravure DRIE en fonction de la valeur dudit paramètre de mesure, en vue de maintenir la valeur du couple élastique desdits spiraux dans une plage donnée,
d - Itération des étapes a, b et c, de manière à contrôler en continu la dispersion du couple élastique des spiraux.

Ce procédé avantageux permet d'obtenir une parfaite maîtrise du couple élastique des spiraux par la méthode de contrôle statistique des procédés. Selon cette méthode les paramètres de gravure sont adaptés d'une plaquette à l'autre pour garder constant et dans la plage voulue, la valeur du paramètre de mesure, et, en finalité, le couple élastique des spiraux.

## Description

### Domaine de l'invention

La présente invention se rapporte au domaine de l'horlogerie. Elle concerne plus précisément un procédé de fabrication d'un lot de spiraux en silicium à partir de plaquettes SOI (Silicon On Insulator), destiné à maintenir la valeur du couple élastique des spiraux dans une plage donnée, avec une faible dispersion au sein du lot.

L'invention concerne également un lot de spiraux fabriqués avec un tel procédé, et une plaquette SOI comportant, après une étape de photolithographie et une étape de gravure DRIE, au moins une structure de spiral et une structure de mesure dont un paramètre est mesurable après une gravure HF partielle, la valeur du paramètre étant corrélée à la valeur du couple élastique du spiral de façon connue.

### Arrière plan de l'invention

Plusieurs effets peuvent réduire l'exactitude de la marche d'une montre : la température, l'amplitude d'oscillations et le magnétisme terrestre peuvent faire varier la fréquence de l'organe réglant et donc diminuer la précision de la montre. Le spiral en silicium permet d'améliorer ces 3 sources d'imprécision. Premièrement le spiral en silicium peut être thermocompensé tel que proposé par la publication EP 1422436. Deuxièmement, différents designs ont été proposés pour garantir une déformation concentrique du spiral : Ainsi par exemple le brevet CH 697207 propose une coupe terminale qui garantit un bon isochronisme, donc la durée des oscillations reste indépendante de l'amplitude. Finalement le silicium est un matériau amagnétique, donc le champ magnétique terrestre n'a pas d'influence sur la marche du spiral.

Toutefois la fabrication d'un spiral en silicium par le procédé de photolithographie suivi de la gravure réactive dans un plasma (DRIE, Deep Reactive Ion Etching) présente quelques difficultés pour bien minimiser la dispersion du couple élastique des spiraux sur une plaquette et la variation du couple élastique d'une plaquette à une autre qui sont produites à des moments différents.

Premièrement pour obtenir une multitudes de spiraux sur une plaquette de silicium son dessin est imprimé sur la plaquette par un procédé de photolithographie. Ce procédé se base sur un masque 10 qui contient un dessin très précis du spiral. Le dessin de ce masque est imprimé sur de la résine photosensible 24 par une exposition à la lumière UV et un développement dans un bain chimique. Il est bien connu à l'homme de métier que les conditions d'expositions et de développement peuvent changer les dimensions des structures imprimées. Ainsi un temps d'exposition trop long ou un temps de développement trop long peuvent réduire la largeur des lignes de résine photosensible. Une erreur allant jusqu'à 0.5 µm d'un batch à l'autre est possible si les paramètres ne sont pas bien contrôlés.

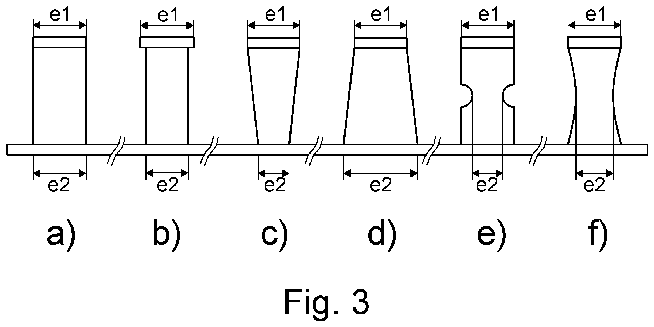

Deuxièmement la méthode du DRIE telle que décrite dans le brevet US 5501893 présente quelques difficultés liées à la nature même de ce procédé de gravure : en effet la gravure plasma a la propriété de présenter une inhomogénéité de vitesse de gravure selon l'endroit sur la plaquette. En particulier la vitesse de gravure du silicium au centre d'une plaquette est généralement plus lente que vers son bord. Cela s'explique par le fait que le plasma est plus réactif à la périphérie qu'au centre. Une gravure plus rapide entraîne une verticalité plus négative (Figure 3c) sur le bord. Une gravure plus lente au centre entraîne une verticalité plus positive (Figure 3a ou 3d) au centre. Ceci se traduit par une dispersion des couples élastiques des spiraux sur une plaquette, donc leur constante de ressort ou leur raideur est différente selon la position sur la plaquette. Ainsi les spiraux qui se situent en périphérie ont un couple élastique plus bas que ceux du centre.

Diverses solutions ont été imaginées pour résoudre cette difficulté. Une première publication EP3181938B1 propose de faire la photolithographie avec des spiraux d'une épaisseur surdimensionnée. Les spiraux sont donc fabriqués avec une épaisseur trop grande. Ensuite quelques spiraux sont enlevé de la plaquette pour déterminer leur couple élastique. Cette mesure permet de calculer l'excès en épaisseur. Une oxydation bien ciblée permet de transformer cette surépaisseur en oxyde. L'oxyde est ensuite enlevé facilement sans graver le silicium. Cette méthode se base donc sur une fabrication itérative avec une mesure du couple élastique de quelques spiraux et la réduction de l'épaisseur des spiraux restants sur la plaquette jusqu'à la valeur cible. Le brevet CH 714815 A2 propose la même méthode, cependant le masque de gravure n'est pas en résine photosensible mais en dioxyde de silicium. Aussi dans cette méthode les spiraux sont d'abord gravés avec une épaisseur trop grande et ensuite amincis à l'épaisseur souhaitée. L'oxyde d'ajustement sert comme protection pendant la gravure de la plaquette « handle » dans un bain d'hydroxyde de potassium pour libérer le spiral du wafer handle. Finalement la publication CH 716603 A1 propose de retirer une surépaisseur de dioxyde de silicium à la fin du procédé pour corriger une trop grande épaisseur produite. Pour contrer l'effet de la dispersion sur la plaquette, les spiraux sont dessinés avec des épaisseurs plus larges au bord.

Ces trois procédés se basent donc sur une fabrication de spiraux trop larges. Un ajustement individuel de chaque plaquette est réalisé par enlèvement de l'épaisseur excédentaire. C'est une approche qui va très bien pour un nombre initial de plaquettes. Mais quand des lots avec un nombre plus élevé de plaquettes sont produits cela devient lourd: en fait cette méthode implique que chaque plaquette doit être retravaillée individuellement, avec un sous-processus différent et adapté à chaque plaquette. Une production par lots de vingt-cinq plaquettes est la norme dans le domaine de la microélectronique. Une telle production par lots, dans laquelle toutes les plaquettes du lot sont soumises aux mêmes paramètres de production, est impossible dans une approche de l'état de l'art. La présente invention propose un procédé basé sur un contrôle continu et son masque de photolithographie associé qui permet une production continue de lots grâce à la maîtrise statistique des procédés.

### Description des figures

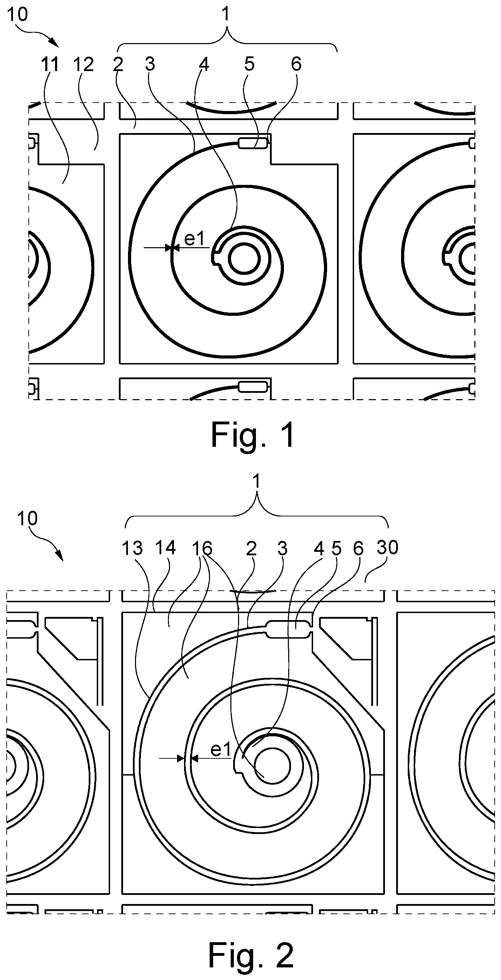

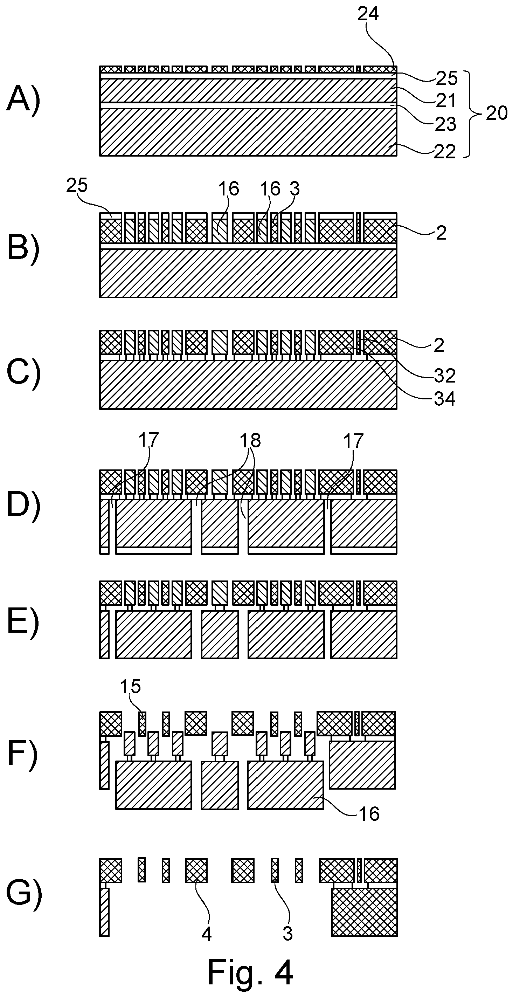

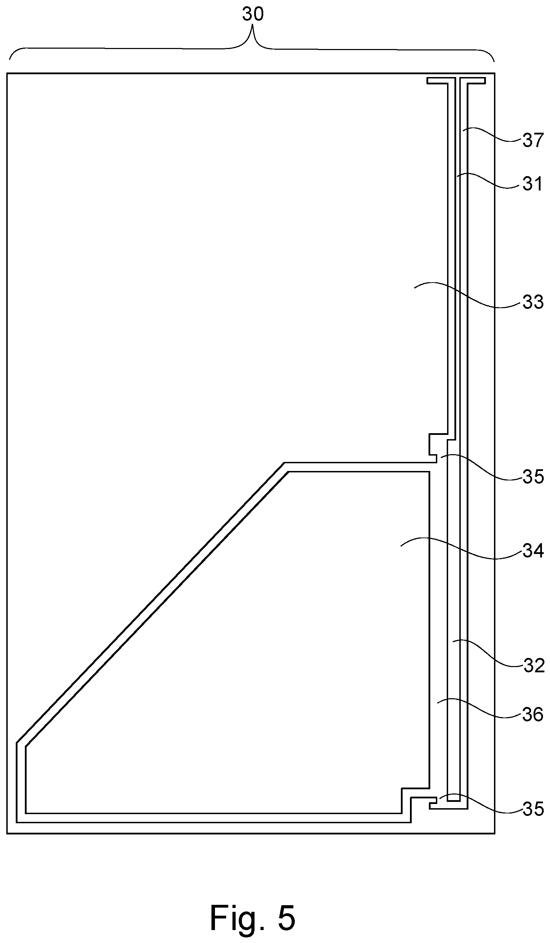

*La* *Figure 1* montre en vue simplifiée de dessus un masque 10 de photolithographie pour la production de spiraux horlogers 3 selon l'état de l'art avec une cellule 1 entière.
*La* *Figure 2* montre en vue simplifiée de dessus un masque 10 de photolithographie pour la production de spiraux horlogers 3 selon l'invention.
*La* *Figure 3* montre différents profils de gravure pouvant être obtenus par ajustement des paramètres de gravure DRIE. L'épaisseur e1 est la largeur du masque de gravure et e2 est la gravure obtenu dans le silicium 3a) gravure verticale idéale. 3b) sous-gravure, 3c) profil négatif, 3d) profil positif, 3e) profil avec «creux», 3f) profil elliptique
*La* *Figure 4* montre des coupes schématisées d'une plaquette SOI au cours de différentes étapes de sa fabrication selon l'invention, ces étapes étant :
   4a) photolithographie sur la couche «device» de hauteur h couvert d'un dioxyde de silicium servant de masque de gravure.
   4b) Gravure DRIE de la couche «device» de la plaquette SOI formant les spiraux 3 et les structures sacrificielles 16.
   4c) Sous-gravure de l'oxyde enterré pour libérer l'actionneur de mesure.
   4d) Gravure DRIE de la couche «handle» face arrière de la plaquette SOI
   4e) Sous-gravure du dioxyde de silicium enterré pour libérer les spiraux.
   4f) Séparation des structures sacrificielles 16 de la plaquette à la fin de l'étape 4e).
   4g) Oxydation pour former le dioxyde de thermocompensation et cellule terminée avec un spiral avec son oxyde thermocompensateur, solidaire de son cadre.
*La* *Figure 5* montre l'actionneur électrostatique de mesure pour déterminer la verticalité de la gravure.

### Description détaillée des modes de réalisation préférés

La Figure 1 montre en vue simplifiée le dessus selon l'état de l'art d'un masque de photolithographie 10 pour la fabrication de spiraux 3 compensateurs. Ce masque contient une multitudes de cellules similaires et chaque cellule contient le dessin du spiral à produire. Ainsi on appellera «cellule» la partie 1 du masque qui sert à produire un spiral 3. Une cellule 1 contient un cadre 2 avec son spiral 3 et, selon l'invention, une nouvelle structure de test 30 qui permet de le produire avec une meilleure précision. Le masque de photolithographie est utilisé pour transférer avec grande fidélité son dessin sur la plaquette de silicium qui contiendra les spiraux. Ainsi le masque contient des zones transparentes 11 dans lesquelles le silicium sera gravé et des zones opaques 12 où le silicium sera gardé. Ainsi le masque définit le spiral 3, avec attache de pitonnage 5, ses spires avec une épaisseur e variable ou constantes et sa virole 4. Le spiral est fixé à la plaquette de silicium par une attache 6 cassable ultérieurement pour séparer le spiral du cadre de chaque cellule sur la plaquette. Dans un but de clarté, seules deux spires sont représentées, mais le composant final peut en contenir un nombre bien plus élevé.

Tous ces modes de réalisation sont bien décrits dans la littérature et font partie du savoir-faire de l'horloger : le silicium permettant une grande liberté de formes. La hauteur du spiral n'est pas définie par le masque de photolithographie mais par la hauteur h de la couche « Device » 21 de la plaquette SOI 20 (Silicon on Insulator). La hauteur h peut être mesurée avec bonne précision et influence à moindre mesure la précision du spiral. Une précision de ±0.5 µm est courante pour la hauteur h de plaquettes SOI.

Donc la première étape de la production du spiral en silicium selon l'état de l'art, commence par l'étape de la photolithographie représenté dans la Figure 4 a). L'épaisseur e du spiral sera déterminée par la largeur des lignes en résine photosensible. Il est bien connu par l'homme de métier comment garantir une bonne reproductibilité de l'épaisseur e par un contrôle dimensionnel de la résine développée et son transfert dans un masque de gravure en dioxyde de silicium 25, par exemple en ajustant le temps d'exposition et/ou le temps de développement. Selon une réalisation moins avantageuse, l'homme de métier pourra utiliser comme masque de gravure directement la résine photosensible développée 24 sans passer par un transfert dans le dioxyde de silicium 25. Mais un masque en dioxyde de silicium 25 interagit moins avec le plasma et il en résulte une meilleure stabilité du procédé de gravure DRIE. Dans les deux cas l'homme de métier sait contrôler la largeur e de manière précise et maintenir constante la différence avec la largeur dessinée sur le masque de photolithographie et d'une plaquette à une autre sur la plaquette de silicium. En effet des appareils de mesure pour déterminer la dimension critique de la photolithographie (en anglais « CD measurement ») existent et permettent de maîtriser cette largeur à une précision largement plus précise que 0.1 µm.

La plus grande difficulté pour fabriquer des spiraux avec une bonne précision vient de la gravure par DRIE. En particulier, maîtriser la verticalité de la gravure est difficile. Pour illustrer cette problématique venons à la Figure 3. Ici sont appelés e1 la largeur des spires du masque de gravure et e2 l'épaisseur finale des spires gravées dans le silicium. Selon les paramètres de gravure l'épaisseur initiale du masque e1 peut être gravée différemment dans le silicium. L'homme de métier peut ajuster les paramètres de gravure pour obtenir différents profils dans le silicium. La Figure 3a) montre une gravure verticale idéale. La Figure 3 b) montre une sous-gravure : une partie de l'épaisseur e1 est perdue et le spiral a une épaisseur réduite e2 mais l'épaisseur est constante sur la hauteur. La Figure 3 c) montre un profil négatif, donc les spires deviennent plus minces avec l'avancement de la gravure. La Figure 3 d) montre un profil positif, ou la gravure produit des spires dont l'épaisseur augmente avec l'avancement de la gravure. L'homme de métier peut aussi arrêter la gravure dans le mode vertical et créer un petit creux comme montré dans la Figure 3 e) pour ensuite continuer avec les paramètres de gravure verticale. Finalement la Figure 3 f) montre un profil elliptique. Bien entendu, diverses modifications et variantes simples peuvent être envisagées par l'homme du métier sans sortir du cadre de l'invention tel que défini par les revendications annexées.

Pour avoir une faible dispersion du couple élastique des spiraux sur une plaquette, il est important que les épaisseurs e1 et e2 (Figure 3) soient identiques sur toute la plaquette et d'une plaquette à une autre, produite à un moment différent. Pour illustrer l'importance du contrôle de la verticalité, nous prenons l'exemple d'un spiral ayant une épaisseur de 20 µm et une hauteur de 120 µm. Une erreur de verticalité de +0.1° entraîne une erreur d'épaisseur moyenne de +0.21 µm. On appellera une « classe » une erreur de marche de la montre de 120 secondes par journée. Ainsi une erreur de +0.1° sur la verticalité, crée une dispersion de 11 classes à 120 sec. Une dispersion de ±0.1° sur la verticalité entraîne déjà une dispersion de 22 classes. On aimerait limiter la dispersion à moins que 40 classes sur une plaquette, ce qui implique qu'il faut maîtriser la verticalité à ±0.18°. Ainsi on peut garder le nombre de classes inférieur à 40 et tous les spiraux d'une plaquette sont utilisables. Garantir une telle précision n'est malheureusement pas possible avec les procédés de photolithographie et de gravure DRIE selon l'état de l'art.

Dans le procédé par DRIE le silicium ouvert au plasma (21) interagit avec les gaz de gravure qui y sont accélérés par les sources radio fréquence du plasma. Le silicium est transformé par les ions de gravure en composé gazeux qui est évacué par les pompes à vide. Mais ces composés ont aussi une influence sur la gravure en cours: en effet ils sont plus concentrés au centre d'une plaquette qu'à la périphérie. Ainsi la vitesse de gravure est plus lente au centre qu'au bord de la plaquette. Une vitesse plus lente de gravure, se traduit aussi par une verticalité plus positive (Figure 3d) au centre et une verticalité plus négative (Figure 3c) au bord.

Pour mieux expliquer ce phénomène revenons au cas de notre spiral avec un pas de 100 µm et une épaisseur de spire de 20 µm : Dans ce cas jusqu'à 75 % de silicium est gravé et seulement 25 % de matière est gardée pour former le spiral 3. Dans un tel cas, la surface de silicium à graver dépasse 20 % de la surface totale de la plaquette, ce qui entraîne une large inhomogénéité de la gravure. La variation des dimensions géométriques dépasse donc de loin notre objectif d'une verticalité précise de ±0.18° entre les spiraux d'une seule plaquette. En effet les composés gazeux produits par la gravure ont une concentration non négligeable par rapport au gaz de gravure et perturbent la gravure. Ces composés peuvent interagir entre eux et devenir plus complexes. En particulier, ils peuvent aussi se redéposer sur la plaquette à graver ou sur les parois de la chambre de réaction. Ainsi la capacité électrique est modifiée par ce re-dépôt ce qui modifie les conditions de gravure d'une plaquette à la suivante. Donc l'énergie des ions qui gravent la plaquette est modifiée par cette capacité parasite et la verticalité dévie de la valeur cible d'une plaquette à la suivante. L'homogénéité de la verticalité est aussi modifiée par ce re-dépôt d'une plaquette à la suivante.

La conséquence d'une large surface à graver est une mauvaise uniformité de la verticalité sur une plaquette et une mauvaise stabilité de la verticalité de plaquette à plaquette. Un contrôle de la verticalité dans la précision demandée devient impossible. Pour cette raison, l'état de l'art utilise des masques avec des dimensions trop grandes et un ajustement de l'épaisseur par des opérations de correction.

Selon l'invention nous voulons éliminer cette opération d'ajustement. Dans ce but, la surface à graver 11 est minimisée en y plaçant une seule ou plusieurs structures sacrificielles 16. La Figure 1 montre un masque de gravure selon l'état de l'art. La surface en couleur blanche 11 montre la zone qui sera gravée. La surface en noir 12 sont les structures qui restent après gravure DRIE. La Figure 2 montre ce masque pour le même spiral selon l'invention. L'espace entre les spires et l'espace entre les spires et le cadre est rempli par une ou plusieurs structures sacrificielles 16. Les structures sacrificielles sont séparées du spiral 3 par un ou plusieurs contours continus 13. Plus avantageusement, ils sont aussi séparés du cadre par un ou plusieurs contours 14 qui fait tout le tour avec le cadre mais laisse une zone fine 6 à l'attache 5 pour garder le spiral solidaire au cadre. Les structures sacrificielles sont solidaires de la plaquette handle 22 seulement par l'oxyde enterré 23. Dans une réalisation moins avantageuse les structures sacrificielles 16 sont solidaires du cadre, il devient donc plus difficile de séparer le spiral de la plaquette. Les structures sacrificielles peuvent être limitées par un seul contour d'une largeur g bien définie ou la largeur peut être variable : La largeur g des contours peut être constante ou variable. Aussi, la largeur g du contour peut rester constante pour tous les spiraux, ou, plus avantageusement, peut varier d'une cellule de spiral à une autre. Nous verrons plus bas pourquoi il sera avantageux d'adapter selon l'invention la largeur du contour d'un spiral à l'autre selon la position sur la plaquette. Nous verrons plus bas aussi comment selon l'invention ces structures sacrificielles 16 seront séparées de la plaquette. Avec les structures sacrificielles nous réduisons les zones à graver et laissons ouverts au plasma seulement des contours, donc la surface ouverte à graver est très réduite. A titre d'exemple, on donnera les valeurs numériques suivantes. Dans le cas de notre exemple d'un spiral avec des spires qui ont une épaisseur de 20 µm et un pas de 100 µm, la largeur 13 qui reste à graver est ainsi réduite de 80 µm à deux fois 10 µm. Donc entre les spires la structure 16 a une largeur de 60 µm et l'ouverture à graver 13 a une largeur de 10 µm. L'influence des gaz de gravure sur la verticalité est ainsi moins perturbée par les produits de gravure chargés en silicium. Donc la gravure par plasma est limitée aux contours 13 et la surface totale à graver est réduite d'un facteur 3 à 10. En effet, nous avons vu plus haut que les produits de gravure et les gaz de gravures tels que l'octafluorocyclobutane (C₄F₈) et l'hexafluorure de soufre (SF₆) peuvent former des composés plus complexes qui rendent la gravure non-homogène et qui en se redéposant sur les parois rendent la gravure non reproductible d'une plaquette à la suivante. Ainsi selon l'invention les structures sacrificielles réduisent la surface à graver et, par conséquent, il y a moins d'interférence et moins de re-déposition et ainsi une meilleure homogénéité à travers la plaquette. En plus il y a moins de variation d'une plaquette à la suivante. On veillera à maintenir une surface ouverte inférieure à 5 % de la surface totale de la plaquette ou, moins avantageusement, une surface ouverte au plasma à moins de 20 % de la surface totale de la plaquette.

Selon l'invention, la surface à graver est adaptée selon l'endroit sur la plaquette. En effet la verticalité de la gravure est liée à la vitesse de gravure. Pour obtenir une même verticalité à la périphérie comme au centre de la plaquette il est avantageux de réduire la vitesse de gravure à la périphérie en y réduisant la largeur du contour 13. Il est bien connu à l'homme du métier que des ouvertures plus petites se gravent plus lentement que les ouvertures plus larges. Ainsi à la périphérie on utilisera une largeur de contour plus petite qu'au centre. A titre d'exemple, on peut prendre 8 µm de largeur pour les contours des structures sacrificielles au bord, contre une largeur de 16 µm au centre. Dans une mise en œuvre avantageuse de l'invention, ce contour de gravure de largeur g 13 est modifié selon la position de la cellule sur la plaquette. Avantageusement selon l'invention, le contour 13 peut avoir une largeur de 5 µm à la périphérie allant jusqu'à 35 µm au centre. L'homme de métier choisira des valeurs intermédiaires à ces valeurs données à titre d'exemple. Les valeurs de largeur du contour 13 peuvent et doivent être variées et adaptées à la géométrie pour optimiser l'homogénéité de la verticalité. L'homme de métier le fera de manière itérative.

Il est important de noter que la distribution de la vitesse de gravure selon l'endroit sur la plaquette suit une courbe plutôt quadratique en direction radiale. Donc la vitesse de gravure entre la périphérie et le centre ne suit pas une loi linéaire, mais est nettement plus rapide au bord de la plaquette et assez plate au centre. Ainsi, les largeurs des contours de gravure ne sont pas adaptées linéairement dans la direction radiale, mais on choisira des largeurs 13 pour obtenir la même verticalité en périphérie qu'au centre, les structures à la périphérie ayant une largeur plus petite que celles au centre. Selon la publication CH 716 603 les épaisseurs des spires sont variées pour réduire la dispersion des couples élastiques. Cette manière de faire est moins avantageuse que de varier les largeurs des contours de gravure parce varier les épaisseurs des spiraux ne peut pas aussi efficacement annuler une dispersion des conditions de gravure et de verticalité que varier les largeurs des contours. En effet, la variation des largeurs des contours est quasi indépendante des conditions de gravure, ce qui n'est pas le cas de la variaition des épaisseurs de spiraux. La méthode qui consiste à varier les largeurs selon l'invention est donc plus robuste contre les dérives du procédé.

Selon l'invention nous avons montré qu'on peut grandement homogénéiser et stabiliser la gravure DRIE en réduisant la surface à graver en dessous de 10 % et plus avantageusement en dessous de 5 % de la surface totale de la plaquette en remplissant les surfaces entre les spires et entre spiral et le cadre par des structures sacrificielles et en choisissant des largeurs de gravure selon l'endroit sur la plaquette.

Pour maintenir les dimensions géométriques des spiraux identiques d'une plaquette à la suivante un moyen confortable de mesure de la géométrie des spiraux est maintenant nécessaire. Selon l'invention, ce moyen simple pour mesurer la verticalité consiste en la structure de mesure 30 présentée dans la Figure 5. Cette structure est un actionneur électrostatique composé d'une poutre de flexion 31 qui a une largeur d avantageusement choisie plus petite que l'épaisseur e des spires. Une électrode d'actionnement 34 permet de faire bouger l'électrode mobile 32. Avantageusement cette électrode mobile 32 est plus large que la poutre de flexion 31 pour permettre une plus grande sensibilité d'observation de son déplacement. Dans une réalisation moins avantageuse l'électrode mobile 32 a la même largeur que la poutre 31. L'ensemble de cette structure est appelé actionneur électrostatique 30 et est placé avantageusement à côté de chaque spiral. Mais aussi seulement un nombre plus limité d'actionneurs électrostatique de mesure 30 par plaquette peut être suffisant. L'actionneur 30 est entouré par un contour de gravure 37 qui a essentiellement la même largeur que le contour 13 rencontré plus haut autour du spiral. Le cadre en dehors de ce contour sert d'électrode de masse 33. Par la nature même de la gravure DRIE cette poutre 31 présente la même verticalité que le spiral, parce qu'elle est entourée d'un contour 37 d'une même largeur d que le contour 13 autour du spiral.

Après la gravure DRIE l'actionneur électrostatique est libéré par une gravure dans l'acide fluorhydrique (HF) en phase liquide ou plus avantageusement en phase vapeur. Les autres structures telles que le spiral 3 et les structures sacrificielles 16 ne sont libérées que partiellement et restent solidaires de la plaquette handle. Toute la plaquette est maintenant placée sous un microscope et les électrodes 33 et 34 sont connectées à une source de tension par des aiguilles. De tels appareils s'appellent «Prober» en anglais et sont bien connus de l'homme de métier en microélectronique. Quand la tension est appliquée par les aiguilles sur les électrodes 33 et 34, la force électrostatique s'exerce sur l'électrode mobile 32 et fait plier la poutre 31. En augmentant la tension continuellement le déplacement de l'électrode 32 suit une courbe quadratique avec la tension. Quand environs 30 % de la distance 36 séparant les électrodes 32 et 34 sont parcourus, l'actionneur électrostatique devient instable et l'électrode 32 se plaque contre la butée 35. Cette tension caractéristique est appelée par l'homme de métier tension de «pull in» ou « tension d'actuation ». La longueur et l'épaisseur de la poutre 31 sont choisies telles que la tension de pull in soit par exemple 30 V. À titre d'exemple, une poutre d'une épaisseur de 5 µm et d'une longueur de 1000 µm donne une tension de pull-in de 30 V si le gap 36 est choisi judicieusement. Nous avons vu plus haut qu'une erreur de verticalité de 0.1° fait varier l'épaisseur équivalente d de la poutre de 0.21 µm. Ce changement de verticalité de 0.1° peut être modélisé par un changement d'épaisseur de la poutre d et la variation de la tension de «pull-in» peut être calculé : Dans notre exemple nous trouvons que ce changement de verticalité de 0.1° entraîne une augmentation de la tension d'actuation de 30 V à 31.9 V. Donc, pour obtenir des spiraux contenus dans une gamme de classe allant de 0 à 40, on veillera à obtenir une tension d'actuation de 30 ± 3.4 V. On notera que ces valeurs sont données à titre d'exemple et chaque référence de spiral aura sa tension caractéristique. Dans une mise en œuvre de l'invention particulièrement avantageuse, l'homme de métier choisira une méthode automatique pour mesurer toutes les tensions des actionneurs repartis sur une plaquette, par exemple à l'aide d'un système de vision automatisé. Il est ainsi possible de mesurer la moyenne, la variation et le changement de la distribution des dimensions géométriques des spiraux sur une plaquette et d'une plaquette à l'autre.

Pour maintenir le processus de fabrication dans une plage de verticalité aussi étroite, il est désormais possible d'ajuster les conditions du processus DRIE d'une plaquette à la suivante lorsque plusieurs plaquettes sont fabriquées les unes après les autres et ainsi maintenir les tensions d'actuation constantes d'une plaquette à la suivante. L'homme de métier sait modifier la verticalité en adaptant le ratio de temps entre les cycles de dépôt de C₄F₈ et de gravure SF₆. Ce ratio des temps de cycles est un moyen facile de changer la verticalité. Par exemple rallonger le temps du cycle de gravure de 0.1 s / cycle réduit l'épaisseur équivalente de notre spiral exemple de typiquement 0.1 µm. Il est donc possible à l'homme de métier de facilement varier la verticalité et ceci, selon l'invention, sur toute la plaquette de manière synchrone grâce aux contours de gravure 13 qui ont des largeurs de gravure adaptées en fonction de la position sur la plaquette. Pour un ajustement plus fin de la verticalité l'homme de métier choisira de modifier la puissance du plasma ou/et le flux des gaz. L'homme de métier choisira de préférence le profil vertical selon la Figure 3a) et essaiera de varier les paramètres pour garder le profil de gravure entre la Figure 3c et la Figure 3d). Selon l'invention la réalisation la plus avantageuse est une gravure avec l'angle proche de la verticalité situé entre +0.1° à -0.5°. Celui-ci donne la meilleure homogénéité à travers la plaquette. Dans une réalisation moins avantageuse l'angle moyen peut être de +0.5° jusqu'à -1.5°.

Le processus selon l'invention consiste donc à mesurer sur chaque plaquette la tension «pull-in» d'au moins un actionneur. Si une déviation est mesurée, l'homme de métier doit adapter les conditions de gravure pour la plaquette suivante pour que la valeur cible des tensions des actionneurs soit maintenue dans la tolérance. Quand la tension d'actuation cible est atteinte pour les actionneurs, les dimensions géométriques des spiraux sont également dans la tolérance souhaitée, de par la relation connue entre la valeur de la tension d'actuation et la valeur du couple élastique. Au début de la mise en production, il y a un nombre limité de plaquettes qui seront mises au rebus, parce qu'elles sont hors tolérance. Il se peut aussi que les dimensions du masque telles que l'épaisseur de la spire e ou la largeur g de contours 13 doivent être adaptées. Donc l'homme de métiers changera le masque de photolithographie plutôt que de s'écarter des conditions idéales de gravure. Une fois que la méthode de la maîtrise statistique des procédés («SPC» en anglais) est mise en place, l'homme de métier peut produire un grand nombre de plaquettes entre la mesure des actionneurs et l'adaptation des paramètres de gravures. Les adaptations deviennent prévisibles. Un flux continu de plaquettes peut ainsi être produit sans reprise de plaquettes individuelles.

Pour finir la fabrication des spiraux, il faut encore pouvoir les séparer de la plaquette handle. Pour faciliter l'enlèvement des spiraux la partie de la plaquette handle qui se situe sous les spiraux est éliminée. Selon l'invention, des lignes de découpe 17 (Figure 4d) sont gravées par DRIE dans la face arrière. Ces lignes sont continues sous chaque cellule de spiral et leur contour est fermé sous chaque cellule, mais les contours ne sont pas reliés d'une cellule à la suivante. Une bonne largeur de ce contour de face arrière se situe entre 20 à 50 µm. Moins avantageusement la largeur du contour de découpe 17 est plus fine, ce qui ralentit la gravure, ou plus large, ce qui consomme plus de place sous le cadre. En dessous des structures utiles plus larges telles que la virole on placera avantageusement des ouvertures de gravure 18 (Figure 4 d). Ces ouvertures 18 sont gravées dans la face arrière par DRIE en même temps que les contours 17. Les ouvertures 18 réduisent la distance à sous-graver dans l'acide fluorhydrique. Après la gravure DRIE de la face arrière la plaquette est placée dans l'acide fluorhydrique (HF) et les structures sacrificielles 16 tombent comme montré dans la Figure 4f). Seul le cadre de la plaquette handle reste solidaire avec les cadres de la couche «device», ou les spiraux restent solidaire au cadre par leur attache 6 du côté du piton.

La dernière étape consiste à oxyder la plaquette pour former l'oxyde thermocompensateur. Selon l'invention les plaquettes sont posées de telle manière que la plaquette est placée à l'horizontale dans le four d'oxydation avec le handle côté inférieur, ceci afin d'éviter que le spiral soit décentré pendant l'oxydation par son propre poids. Selon l'invention les spiraux ne sont pas en contact avec le support mais sont maintenus à l'air par le plaquette handle.

Pour récapituler le procédé de fabrication selon l'invention revenons à la Figure 4. Le procédé commence avec une plaquette SOI 20 qui consiste en une couche device 21, une couche de dioxyde de silicium enterrée 23 et la couche handle 22.

Figure 4 a) : par photolithographie les formes des spiraux sont transférées sur un masque de gravure (en résine photosensible 24 ou transférées en dioxyde de silicium 25). Les largeurs critiques de cette étape sont mesurées et les paramètres de photolithographie, respectivement les paramètres du transfert dans le dioxyde de silicium, sont adaptés pour maintenir ces lignes avec une précision meilleure que 0.05 µm.

Figure 4 b) : la deuxième étape consiste à graver dans le silicium par DRIE. Ici les paramètres de gravure sont maîtrisés pour que les formes géométriques des spiraux soient dans la tolérance voulue.

Figure 4 c) : Pour pouvoir mesurer la verticalité de la gravure les actionneurs électrostatiques sont libérés dans l'acide fluorhydrique. Selon le résultat de cette mesure les paramètres de gravure des prochaines plaquettes sont maintenus ou adaptés pour garder la tension d'actuation dans une plage prédéfinie. Les autres structures 15 telles que les structures sacrificielles 16 et les spiraux 3, restent solidaires de la plaquette handle parce que le dioxyde de silicium est seulement partiellement sous-gravé sous ces structures utiles 15.

Figure 4 d) : Dans la face arrière sont gravés par DRIE un contour de gravure 17. Ce contour a essentiellement la même forme que le contour 14 de la face avant, mais le contour face arrière 17 est fermé. En plus il est un peu plus déplacé vers l'extérieur sous le cadre pour ne pas chevaucher sur le contour 14, mais s'arrêter sur le dioxyde enterré 23. Pour découper les zones sous le spiral ce contour 17 est placé en dessous du cadre. Donc il découpe une zone plus grande que le contour face avant 14.

Des structures telles que la virole 4 ou l'attache 5 peuvent être sensiblement plus larges que l'épaisseur du spiral. Pour réduire le temps de sous-gravure dans l'acide fluorhydrique, on gravera avantageusement par DRIE sous ces structures des ouvertures. Ces ouvertures sont typiquement en retrait d'un peu plus de la moitié de la largeur du spiral. Par exemple si l'attache a une largeur de 80 µm, en veillera à faire une ouverture sous cette forme qui aura une largeur de 50 µm, ce qui est la largeur de l'attache moins un peu plus de la largeur du spiral.

Une fois la gravure DRIE face arrière faite, la sous-gravure dans l'acide fluorhydrique peut être reprise comme montré dans la Figure 4 e). Les zones des structures sacrificielles qui sont restées solidaires du cadre et des structures utiles 15 par le dioxyde de silicium enterré sont libérées.Sans le lien fourni par cet oxyde, la structure sacrificielle tombe comme montré dans la Figure 4 f).

Finalement comme montré dans la Figure 4 g) le dioxyde de silicium thermocompensateur est créé par oxydation thermique.

Des variantes dans ce procédé de fabrication sont possibles. Il sera particulièrement avantageux de faire l'étape d de la Figure 4 tout au début du procédé pour pouvoir faire l'étape dans l'acide fluorhydrique 4 c) et 4 e) en même temps. En effet la sous-gravure de l'actionneur et la libération des structures sacrificielles sont faites en même temps. Cette variante, où l'étape d est réalisée avant l'étape a, utilise les mêmes masques de photolithographie, mais elle permet de réduire le nombre d'étapes et obtenir le même résultat final.

Ainsi a été décrit :
- Un procédé de fabrication d'un lot de spiraux en silicium à partir de plaquettes SOI (Silicon On Insulator), destiné à maintenir la valeur du couple élastique des spiraux dans une plage donnée avec une faible dispersion au sein du lot, et
- Une plaquette SOI comportant, après une étape de photolithographie et une étape de gravure DRIE, au moins une structure de spiral et une structure de mesure dont un paramètre est mesurable après une libération partielle desdites structures par une gravure HF, la valeur mesurée étant corrélée à la valeur du couple élastique dudit spiral de façon connue.

Bien entendu, la présente invention ne se limite pas aux modes de réalisation décrits ci-dessus, et diverses modifications et variantes simples peuvent être envisagées par l'homme du métier sans sortir du cadre de l'invention tel que défini par les revendications annexées.

### Déclaration numérique

- 1: Cellule avec un spiral
- 2: cadre
- 3: spires
- 4: virole
- 5: attache de pitonnage
- 6: attache au cadre
- 10: Masque :
- 11: zones à graver
- 12: zones qui restent en silicium
- 13: contour de gravure de largeur g autour du spiral
- 14: contour de gravure séparant les structures sacrificielles du cadre
- 15: structures utiles qui restent attaché à la plaquette à la fin du procédé
- 16: structures sacrificielles qui partent après la gravure de l'
- 17: contour de gravure face arrière séparant les structures sacrificielles du cadre
- 18: ouverture de gravure face arrière pour libérer grandes structures
- 20: plaquette SOI :
- 21: couche «device» de la plaquette SOI
- 22: couche «handle» de la plaquette SOI
- 23: dioxyde de silicium enterré
- 24: masque en résine photosensible
- 25: masque de gravure en résine photosensible ou en dioxyde de silicium
- 30: actionneur électrostatique de mesure
- 31: poutre de largeur d
- 32: électrode mobile relié à l'électrode de masse par la poutre 31
- 33: électrode de masse
- 34: électrode d'activation
- 35: butée
- 36: distance entre l'électrode d'activation 34 et l'électrode mobile 32
- 37: contour de gravure autour de la poutre 31.
- e1: épaisseur de spire en haut du spiral définie par la photolithographie
- e2: épaisseur de spire en bas du spiral définie par la gravure
- g: largeur de gap
- h: hauteur de la couche device de la plaquette SOI

## Revendications

1. Procédé de fabrication d'un lot de spiraux en silicium à partir de plaquettes SOI (Silicon On Insulator) (20) destiné à maintenir la valeur du couple élastique desdits spiraux dans une plage donnée, comprenant, dans l'ordre, les étapes suivantes :
a - Photolithographie et gravure DRIE d'au moins une plaquette SOI, sur laquelle au moins une structure de spiral et une structure de mesure (30) sont présents,
b - Mesure d'un paramètre de ladite structure de mesure (30), la valeur dudit paramètre de mesure étant corrélée à la valeur du couple élastique du spiral de façon connue,
c - Ajustement fin des paramètres de photolithographie et gravure DRIE en fonction de la valeur dudit paramètre de mesure en vue de maintenir la valeur du couple élastique desdits spiraux dans ladite plage donnée,
d - Itération des étapes a, b et c, de manière à contrôler en continu la dispersion du couple élastique des spiraux.

2. Procédé de fabrication d'un lot de spiraux en silicium selon la revendication 1, **caractérisé en ce que** ladite structure de mesure (30) est un actionneur électrostatique, et **en ce que** ledit paramètre de mesure est sa tension d'actuation, la valeur de ladite tension étant corrélée à la valeur dudit couple élastique de façon connue.

3. Procédé de fabrication d'un lot de spiraux en silicium selon la revendication 2, **caractérisé en ce que** ledit actionneur électrostatique comporte une poutre (31) de largeur d inférieure à l'épaisseur e1 du spiral, de manière à accentuer les effets de la photolithographie et de la gravure DRIE sur la valeur de ladite tension d'actuation.

4. Procédé de fabrication d'un lot de spiraux en silicium selon la revendication 3, **caractérisée en ce que** ladite poutre (31) de largeur d est libérée totalement par une étape de gravure HF, laissant les autres structures au moins partiellement solidaires de ladite plaquette SOI (20).

5. Procédé de fabrication d'un lot de spiraux en silicium selon les revendications 1 à 4, **caractérisé en ce que** ladite gravure DRIE est constituée d'une alternance de cycles de dépôt et de gravure, et **en ce que** le paramètre principal de réglage de la gravure est le ratio en temps desdits cycles.

6. Procédé de fabrication d'un lot de spiraux en silicium selon la revendication 5, **caractérisé en ce que** les autres paramètres importants de réglage de la gravure sont le flux des gaz et la puissance du plasma.

7. Procédé de fabrication d'un lot de spiraux en silicium selon la revendication 1, **caractérisé en ce que** ladite structure de mesure (30) est le spiral lui-même et **en ce que** le paramètre de mesure est le couple élastique.

8. Lot de spiraux fabriqués à l'aide du procédé de fabrication selon les revendications 1 à 7, grâce auquel la valeur du couple élastique desdits spiraux est maintenue dans une plage donnée avec une faible dispersion.

9. Plaquette SOI (20) comportant, après une étape de photolithographie et une étape de gravure DRIE, au moins une structure de spiral et une structure de mesure (30) dont un paramètre est mesurable après une libération partielle desdites structures par une gravure HF, la valeur dudit paramètre étant corrélée à la valeur du couple élastique du spiral de façon connue.
